Europäisches Patentamt

European Patent Office

Office européen des brevets

(19)

(11) Publication number: **0 267 379**

**A2**

(12) **EUROPEAN PATENT APPLICATION**

(21) Application number: 87112429.3

(51) Int. Cl.⁴ **G06F 15/60**

(22) Date of filing: 26.08.87

(30) Priority: 12.09.86 US 907515

(43) Date of publication of application:
18.05.88 Bulletin 88/20

(84) Designated Contracting States:
AT BE CH DE ES FR GB GR IT LI LU NL SE

(71) Applicant: **DIGITAL EQUIPMENT CORPORATION**
**146 Main Street**
**Maynard, MA 01754(US)**

(72) Inventor: **Hooper, Donald F.**
**13 Thoreau Road**
**Northboro Massachusetts 01532(US)**
Inventor: **Kundu, Snehamay**
**84 Bergeron Road**
**Marlboro Massachusetts 01752(US)**

(74) Representative: **Patentanwälte Grünecker,**
**Kinkeldey, Stockmair & Partner**
**Maximilianstrasse 58**
**D-8000 München 22(DE)**

(54) Data base access mechanism for rules utilized by a synthesis procedure for logic circuit design.

(57) In a circuit design synthesis procedure in which the pointers are added to the data base to permit a path through the circuit to be followed. a qualified object is defined to be a data object that permits access expressed by a sequence (or chain) of access forms strung together. A mechanism is defined that permits access of any other object in the data base. Access forms are strung together in a given format. This structure provides an easily understandable access form and it is defined in the rule grammar. This access form can be parsed in the synthesis procedure into a nest of (LISP) program functions. which, when evaluated. will return an object in the data base. This access chain is used in the antecedent portion of the rule structure for the purpose of modifying the target objects. This access structure permits the synthesis rules to make decisions on such parameters as timing, cell size. power. wire loading. model names. etc. The rules of the synthesis procedure can be written in such a manner as to be similar to a circuit designer's rules. In addition to the access of objects. this chained access structure also permits tagging (or marking) a subset intermediate objects to be temporarily saved for use by the synthesis rules. This additional capability provides the ability to sort and partition sets of objects based on attributes and permits a synthesis procedure capable of using abstract tradeoffs.

FIG. 6.

Xerox Copy Centre

BAD ORIGINAL

# DATA BASE ACCESS MECHANISM FOR RULES UTILIZED BY A SYNTHESIS PROCEDURE FOR LOGIC CIRCUIT DESIGN

## BACKGROUND OF THE INVENTION

### 1. Field of the Invention

This invention relates generally to circuit design synthesis and, more particularly, to procedures for accessing data base structures or objects of the synthesis program.

### 2. Description of the Related Art

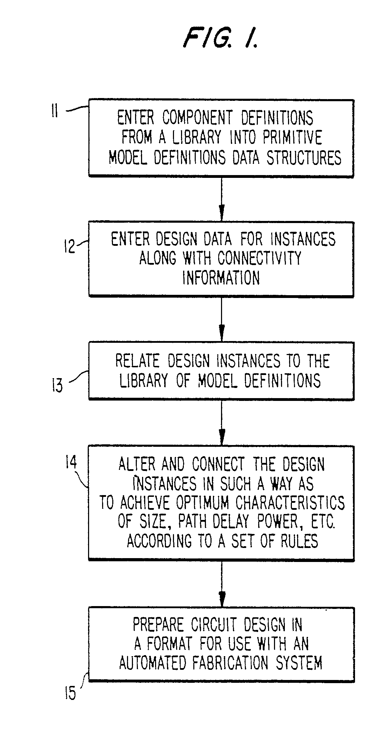

Referring next to Fig. 1, the procedure for synthesizing a logic circuit design according to the prior art is shown. Model definition data structures from a library of component definitions is entered into the data structures associated with the synthesis data base in step 11. In step 12, the information related to the instances of the circuit design including the connectivity information is entered in the data base. The instances of the circuit design are generally in a behavioral or functional form when entered in the synthesis data base. The synthesis procedure relates the instances of the circuit design to the model instances in step 13. In step 14, a set of rules for the synthesis procedure is applied to each of the model instances and the model instances are altered and connected in such a way as to maximize certain parameters such as size, path delay, power, etc. In step 15, the resulting circuit design is placed in a format that can control the automated fabrication of the circuit.

In order to make decisions regarding such data base parameters as timing, cell size, power requirements, wire loading, model names, etc., a rule must access data structures in the synthesis system data base. The synthesis procedures of the related art can typically perform similar access operations only by evaluation of the entire circuit. A need has therefore been felt for a synthesis procedure and related syntax data access structures that will permit the access of data base objects at the end of a sequence of data base objects. Similar to OPSS, our access functions permit inspection of various slots (fields) of a data structure. But unlike OPSS, our access functions allow referencing data objects more than one field forward and backward along a circuit path if needed, with respect to any specific data object. This ability is an essential ingredient of access forms that assist in electrically inspecting sequences of connected components.

## FEATURES OF THE INVENTION

It is an object of the present invention to provide an improved procedure for the synthesis of circuit designs.

It is a feature of the present invention to permit simple access forms and mechanism to inspect a data base structure object in order to write rules of physical logic synthesis.

It is another feature of the present invention to provide a capability of accessing subsets of data base objects at intermediate locations in a chain of data base objects.

It is yet another feature of the present invention to provide a synthesis procedure capable of accessing a plurality of data base objects affecting a target data base object.

## SUMMARY OF THE INVENTION

The aforementioned and other features are obtained, according to the present invention, by providing a synthesis procedure and related data base organization to permit a noun in a rule structure to be interpreted as a sequence of data base objects, the rule syntax permitting the access to either an end member of the sequence and/or marking or tagging an intermediate member of the sequence. This syntax provides the ability to sort and partition tagged sets of data base objects based on their attributes.

These and other features of the present invention will be understood upon reading of the following description along with the drawings.

## BRIEF DESCRIPTION OF THE DRAWINGS

Figure 1 is a flow diagram of the procedure for the synthesis of circuit designs according to the related art.

Figure 2 is a flow diagram of an inventive procedure for the synthesis of circuit diagrams capable of supporting the present invention.

Figure 3 is an overall diagram of the architecture for data structures of the logic design data base and the logic synthesis rules data base.

Figure 4 is an detailed illustration of the hierarchical relationship of the objects of the design model as it is transferred between external software mechanisms and this system.

BAD ORIGINAL

Figure 5 is an example of the access of a logic design data base by following pointers through an sequence of objects and/or functions according to the present invention.

Figure 6 is an example of the access of values which are calculated or derived, as opposed to stored data base objects according to the present invention.

Figure 7 is an example of the tagging of objects at the midpoint of a qualified object access, and the temporary tag pointers which are established for subsequent access by the rule according to the present invention.

Figure 8 illustrates the access from the current model instance to attributes of the parent model definition according to the present invention.

Figure 9 illustrates the access from the current model instance to attributes of the current design according to the present invention.

## DESCRIPTION OF THE PREFERRED EMBODIMENT

### 1. Detailed Description of the Figures

Fig. 1 has been described in relationship to the related art.

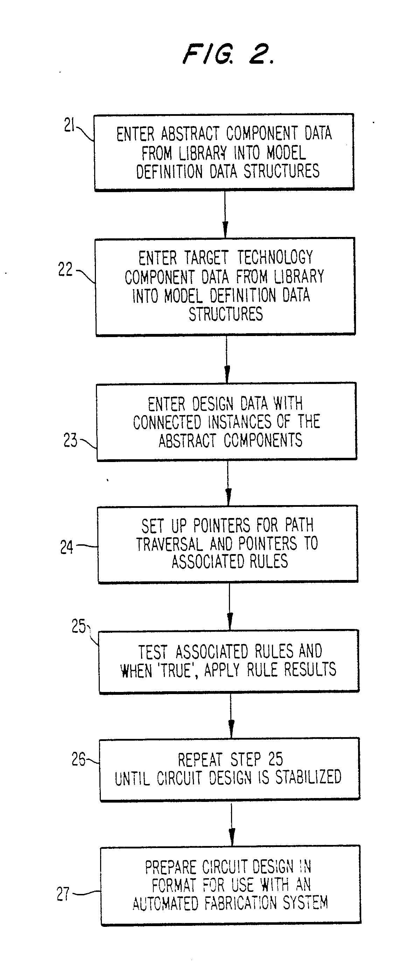

Referring next to Fig. 2, the synthesis procedure of the present invention is shown. In step 21, abstract component data from a library of such data is entered into model definition data structures of the synthesis procedure. In step 22, component data relating to the target technology from the library is entered into model definition data structures of the synthesis procedure. The circuit design data with the connected instances described in terms of abstract components is entered into the synthesis procedure in step 23. In step 24, the synthesis procedure provides two sets of pointers. The first set of pointers permits the synthesis procedure to follow any arbitrary path through the design circuit. The second set of pointers couples rules with associated data base structures. In step 25, the associated rules are tested for each instance and when the test provides a 'true' result, the consequences of the rule is implemented. In the preferred embodiment, each rule has an antecedent portion and a consequence portion. The antecedent portion includes a test algorithm, and the consequence portion provides the information required to implement a result of the test. Because the rules are applied to instances in a sequential manner, and because, in the preferred embodiment, the test procedures can involve neighboring instances that were changed as a result of a test applied to that instance, the process is repeated until the circuit design is stabilized. In step 27, the final version of the circuit design is placed in a format suitable for use in an automated circuit fabrication system.

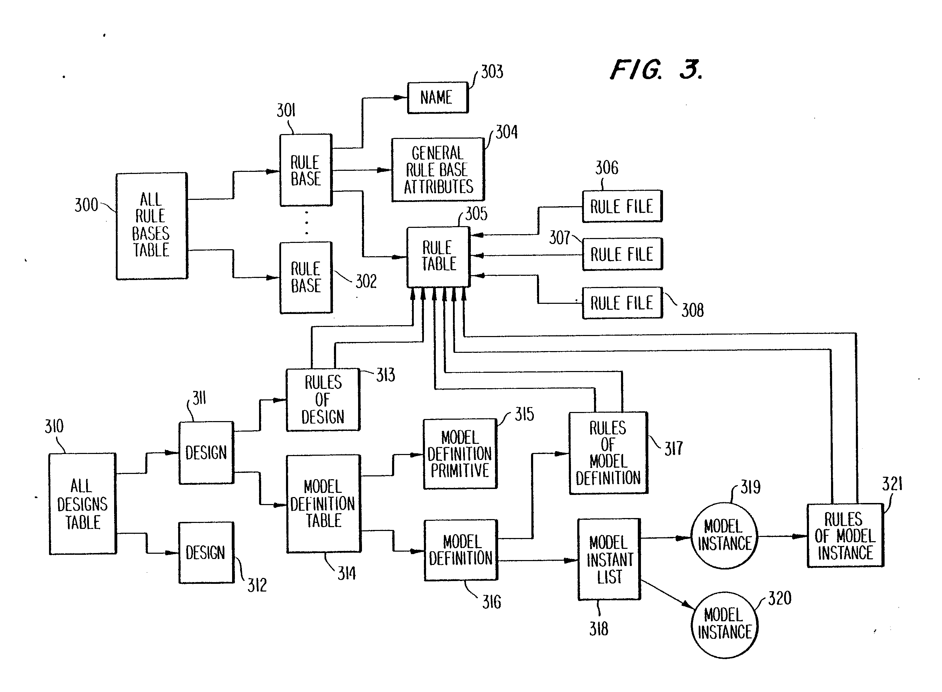

Referring now to Fig. 3, the architectural organization for the storage of the logic synthesis rules and the logic design rules are shown. Two storage hierarchies are available, one representing rule information and the second representing digital design information. These information hierarchies interact when pointers are established, relating the design objects to specific groups of rules. A rule file 306 through 308 is collection rules arbitrarily organized by the creator of the file. Several rule files can be transferred to a rule table 305. The rule table 305 is a lookup table that is indexed by the name of the rules stored therein. The rule table 305 is an attribute of a rule base 303 that has in addition to the rules stored in rule table 305, a name 303 and other attributes 304 of the rule base. Any number of rule bases 301 through 302 are contained in the table of all of the rule bases 300. The all rule bases table 300 is a lookup table indexed by the name of the rule base. The all rule bases table 300 is the top of the rule information hierarchy. The logic design data is partitioned into blocks, called model definitions can be stored in the model definition table, a lookup table indexed by the model name. A model definition can contain a model instance list 318 that includes model instances 319 and 320 that also can be model instances of other model definitions. For any functional part type or structural body of a given name, only one model definition can exist. However, any functional part type of structural body can have 0 or more model instances. The attributes of the model definition are common to all of the model instances associated therewith and, therefore need to be stored only with the model definition. The attributes of the model instances, such as timing parameters and simulation values, are unique to each model instance and consequently must be stored with the associated model instance. Those model definitions with no model instances or for which a "LIBRARY" attribute is specified are considered primitive model definitions stored in table 315. The model definition table 314 is stored in a design table 312, the design table capable of possessing other attributes. Any number of designs 311 through 312 can be contained in the all designs table 310.

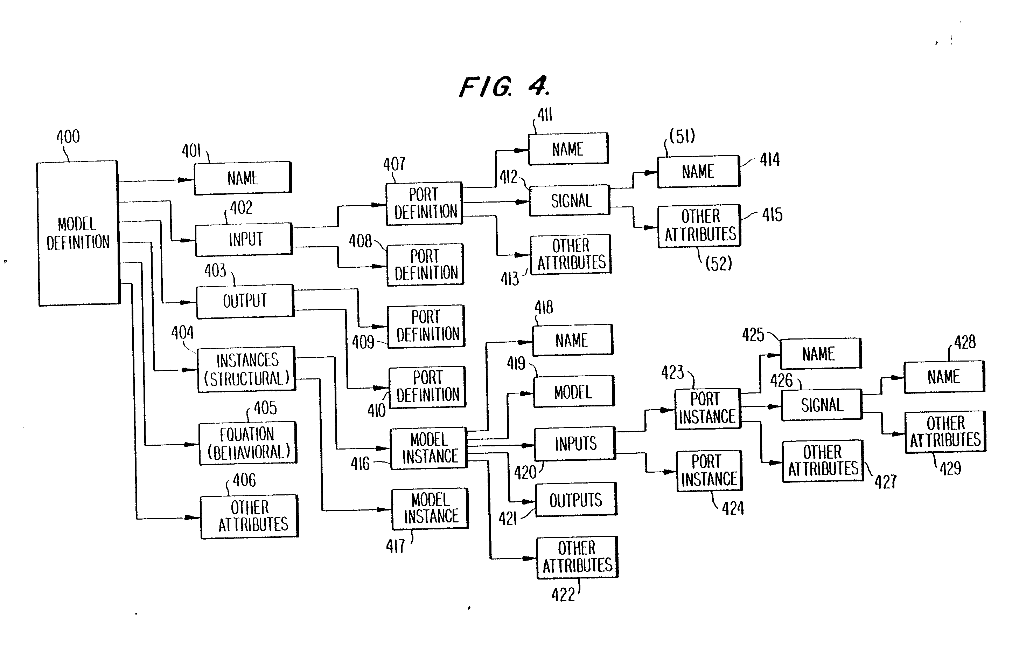

Referring to Fig. 4, the interface form of the model definition is shown. Each model definition has a name 401, an interface definition comprising input signals 402 and output signals 403 and other attributes 406. Each model definition can have a schematic, structural or data flow form in which case the model definition would have instances 404. Furthermore, a model definition can also have

BAD ORIGINAL

a functional form or a behavior form 405. The input interface signals are tied to port definitions 407 and 408 and the interface output signals are also tied to port definitions 409 and 410. There can also be other types of interface signals such as by directional signals. Port definitions have a name 411, a signal 412, and other attributes 413. The signal of a port definition has a name 414 and other attributes 415. The model instances 404 can have a plurality of individual model instances 416 and 417 included therein. Each model instance 416 and 417 has a unique name 418, a name of its model definition 419, input and output interface instances 420 and 421 and other attributes 422. The interface instances 420 and 421 consist of port instances 423 and 424, while each port instance has a name 425, signals 426 and other attributes 427. each signal has a name 428 and other attributes 429.

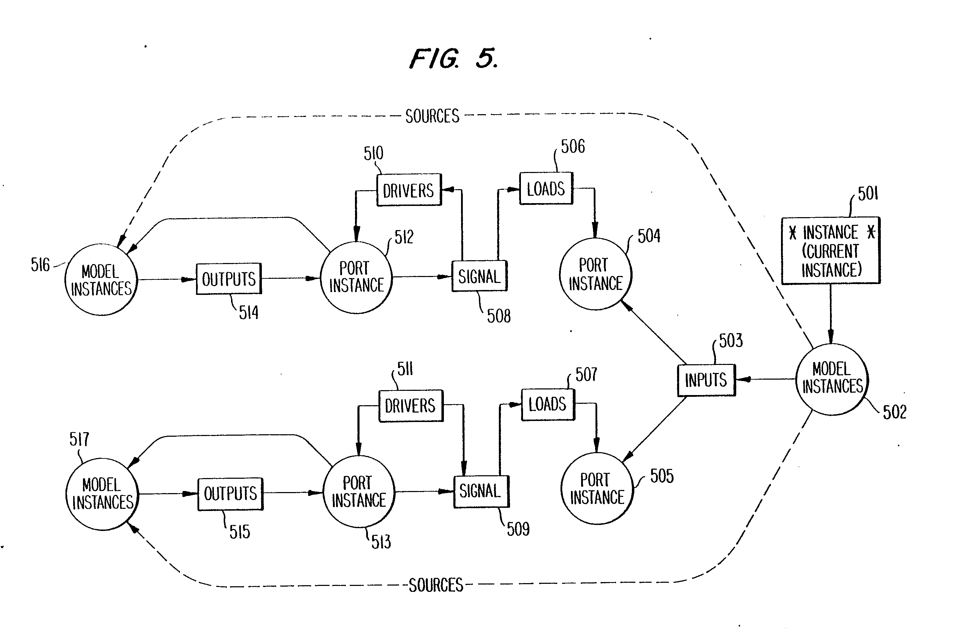

Referring next to Fig. 5. the access of a logic design data base by following pointers through the sequence of objects and/or functions is shown. A rule is assumed to be referring to the current instance, "instance", 501 and 502. The access syntax 'INPUTS' implies access to the list of objects 503, inputs of the model instance 502. The access syntax '1ST-INPUTS'. '1ST-INS'. '1ST-INPUT' or '1ST-IN' implies access to the port instance object 504. The access syntax 'SIGNALS-OF-INPUTS' implies access to signals 508 and 509. One method for accessing model instances 516 and 517 from the current instance is to use the chain 'INSTANCES-OF-DRIVERS-OF-SIGNALS-OF-INPUTS'. The access will follow the path of inputs 502, 504 and 505 to signals 508 and 509 to drivers 510, 511, 512 and 513 to model instances 516 and 517. Because this path is frequently used. a "synonymous" name is defined so that the use of the term 'SOURCES' will provide the list of instances coupled to the inputs side of the current instance. Conversely, the term 'DESTS' is defined to provide the list of instances connected to the output side of the current instance. The term 'SOURCES-OF-SOURCES' can be used to obtain a list of the sources of instances 516 and 517. If there are no sources, a null indication will be returned.

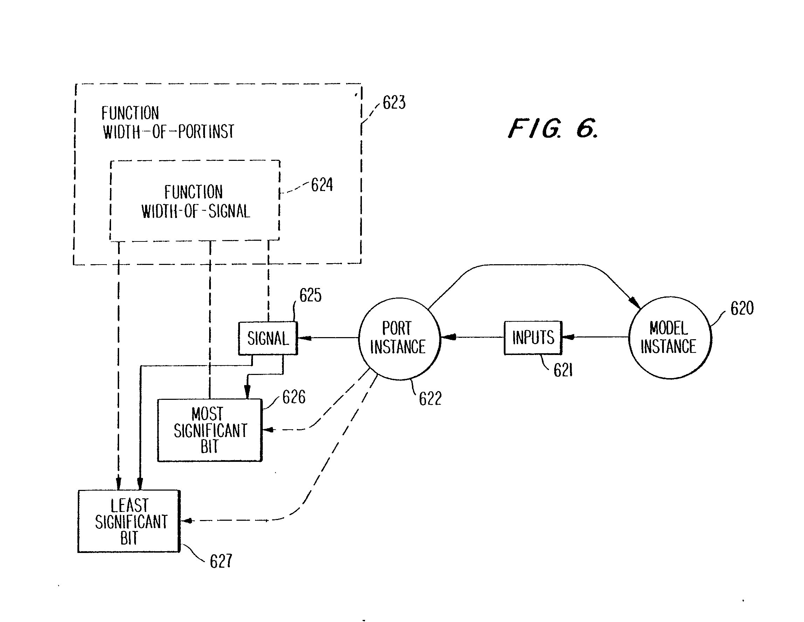

Referring next to Fig. 6. the derived access of a signal's width is illustrated. The signal width, for purpose of this illustration. is defined as the number of binary bits of a data path which the signal represents. The signal may have a least significant bit and a most significant bit, the convention of most binary digital computers. The width does not exist as a data base attribute, but is instead derived or calculated whenever asked for By using the access name "WIDTH OF SIGNAL OF-FIRST-INPUT". the recursion computation method follows backwards from model instance 620 to its inputs 621 to the first input 622 to signal 625. This function takes a signal as an argument, gets the most significant bit 626 and the least significant bit 627, calculates the width and returns it. The width is then passed back to the rule antecedent. An implied "equivalence" is built into the function 'WIDTH OF PORTINST' 623. Because of it, a simpler access name 'WIDTH OF 1ST INPUT' will return the same value as 'WIDTH OF SIGNAL OF 1ST INPUT'.

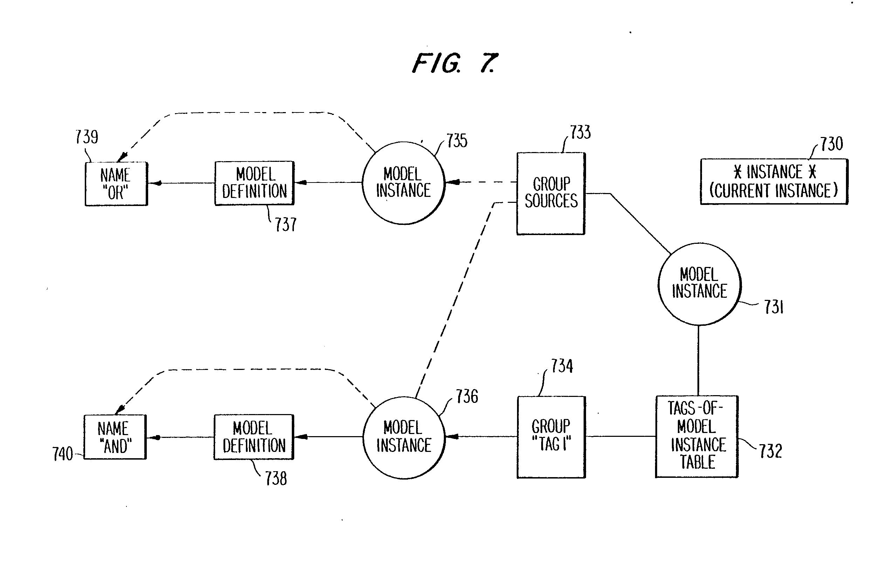

Referring to Fig. 7, the operation of "tagging" a subset of data base objects at midpoints in a group of access paths is illustrated. A rule at the current model instance 730 and 731 may have an antecedent (ANY MODELS-TAG1 SOURCES ARE "AND"). The sources of model instance 731 are in group 733 or model instances 735 and 736. The collective search path continues backward for sources which are instances producing the input signals of the "current instance" through model definitions 737 and 738 to the names of model definitions 739 and 740. The terminal points of the search paths are the group of model names. ("OR", "AND"). The verb 'ARE' and the sentence primitive object "AND" are evaluated against each item in the group ("OR", "AND") returning a group of verdicts ('nil', 'true'). The 'ANY' function determines also the mid-paths group of potential taggable objects 735 and 736 because they follow the tag identifier 'TAG1'. The results of the evaluation of the end points ('nil'. 'true') may now be used as a mask against the taggable objects to get that subset of the group 735 and 736 which is marked with 'true'. This operation produces the result group 734 of model instances 736 which is placed in a table of tags 732 of the current instance modelinst 731 under the index 'TAG1'. For the remainder of the rule, the 'TAG1' may be accessed as a normal data base object pointed to by the current instance of this "skip" above access evaluation. It is possible to give an arbitrary name to the tagged object by using curly brackets. For example, the following antecedent may be used:
(ANY MODELS-TAG AND__{GATES} -SOURCES is "AND").
In this case. the tagged object 736 is put in a group 734 in the table of tags of the current model instances 732 under the index (AND__GATES), and maybe accessed by using the term (AND__GATES) for the remainder of the rule.

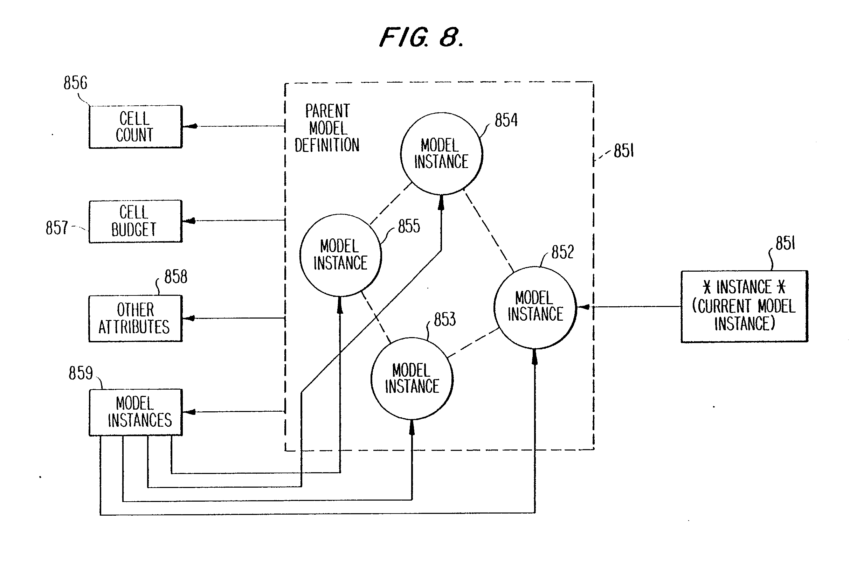

Referring next to Fig. 8. data base access of the parent model definition is illustrated. In the preferred embodiment. the keyword PARENT implies the parent of the current model instance, which is the current model definition. A rule could therefore follow current model instance 850 and 852 to parent 851 to any of the data base attributes of the parent 856, 857, 858 and 859. Among the

BAD ORIGINAL

attributes of the parent is a group 859 of model instances 855, 854, 853 and 852 of which the current model instance is one. In this manner, hierarchy may be followed upward to access more global data base parameters. It would be possible, following this convention, to access global technology parameters by going to the top level of the design data base, the current design.

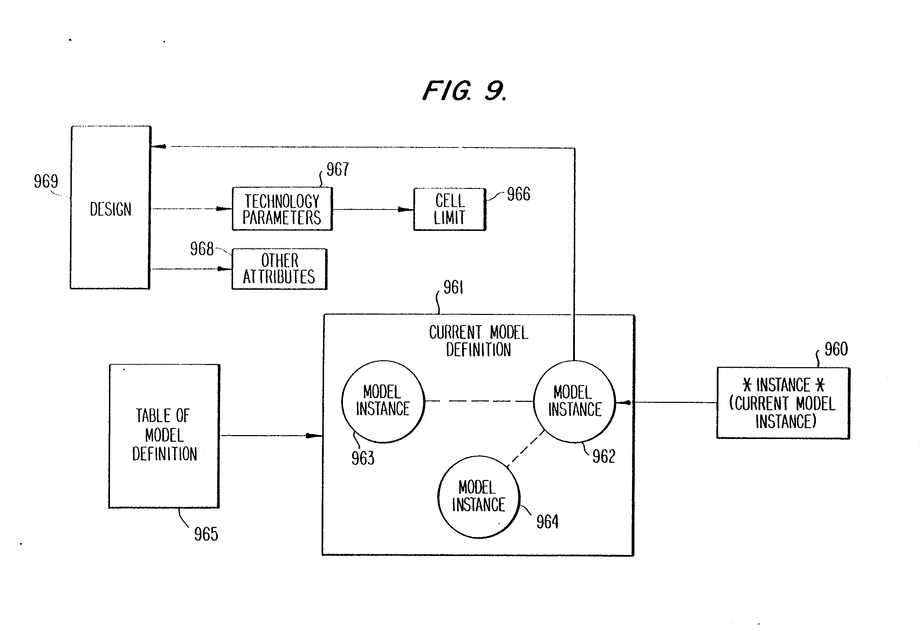

Referring to Fig. 9, the access of the data base by more global parameters is illustrated. By going from the current model instance 960 and 962 to the current design 969, to the technology parameters 967, such a cell count limit 966, may be accessed. Attributes at the design level typically are applicable to more than one model definition resident in the same design.

## 2. Operation of the Preferred Embodiment

Rules are used to encode that knowledge of a logic designer which causes a logic design in one form, i.e., boolean to be changed into a functionally equivalent logic design in another form such as technology components. The logic design data is kept in a data base hierarchy of design model definitions in a current design. Rules operate on the model instances of a current model definition. The model instances are structural operators or components interconnected by data base objects, port instances and signals. Collections of port instances also make up the path of pointer established by the data base.

The rule grammar has places in its sentence formats for qualified objects. The rule sentence, as entered in its textual entry format, needs to be concise, readable, and easily understandable. The assumption is made that the rule, at interpretation time, will perform tests and make changes to data relative to a current model instance, which is one of the model instances of the current model definition. The qualified objects in the rule being executed therefore need to provide complete access to the design data near or in some mannner related to the current instance. The data base has pointers permitting the "walking" from the current instance (from object to object) until arrival at a desired end point. By stringing together the names of objects, separated by '-' or by '-of-', or some other character combination, a qualified noun can be created. If the walk is through many objects and is performed frequently, a name for "skip" across several objects may be defined, so that the syntax of the qualified noun is thereby shortened. If the data is desired that is not explicitly an object or attribute of the data base, a name for deriving the data may be defined, and tried in the qualified access string as if it were just another object in the data base.

When the rule for each qualified object is parsed and converted into executable form, the string of access forms becomes a nest of program functions with one argument, the current instance. During rule interpretation, the nest is (sometimes) recursively evaluated, causing the "walk" to the desired data base object (or group thereof) as the access evaluation phase is entered. The "walk" can also occur along sets of objects, returning a set or subset as the accessed item.

In the sentence format (ANY <qualified-object> <verb> <object>), when a TAGn or 'TAG {object}' is placed in the access string of the <qualified-object>, the end qualified-object must be a group or list. The evaluation of the qualified of qualified-object causes several pointer paths to be followed in the logic design data base to arrive at the end point. Those end datum which, when applied with <verb> and <object> return a 'true' verdict, cause their individual access paths to be marked as 'true'. Those objects which followed the 'TAG' identifier and also which are on paths marked true are now grouped together and placed in a table of tagged items of the current instance. The tagged items may now be accessed by the remainder of the rule as normal data base objects. A tag item is valid within a rule where it was first evaluated and thus defined. The tagging of data base objects and attributes allows the rule to perform set manipulations easily by "skipping" evaluation of the same access function several times and by making decisions on relative data as opposed to absolute data. When the rule is exited, the table of tagged items is erased.

The foregoing description is included to illustrate the operation of the preferred embodiment and is not meant to limit the scope of the invention. The scope of the invention is to be limited only by the following claims. From the foregoing description, many variations will be apparent to those skilled in the art that would yet be encompassed by the spirit and scope of the invention.

## Claims

1. In a procedure for synthesizing circuit designs, a method for accessing a data base structure at a non-adjacent locations comprising the steps of:

creating a data base structure in which coupled objects of said data base structure can be accessed in any order; and

providing a noun to be parsed by said synthesizing procedure, said noun being interpreted as a sequence of nested functions by said synthesizing procedure.

BAD ORIGINAL

2. The method for accessing a data base structure of Claim 1 further including the step of providing at least one data base object in said noun.

3. The method for accessing a data base structure of Claim 2 further including the step of providing a plurality of sequential data base objects in said noun.

4. The method of accessing a data base structure of Claim 1 further including the step of providing said function name in said noun, said function name providing a derived data as opposed to direct access to data.

5. The method of accessing a data base structure of Claim 3 further including the step of treating a predetermined one of said plurality of data base objects as and argument of an associated rule.

6. The method of accessing a data base structure of Claim 3, wherein said plurality of data base objects is a path in said circuit, the method further including the step of branching from a single path to groups of paths by following data base pointers to data base objects designated as groups of data base objects.

7. The method of accessing a data base structure of Claim 6 further including the step of selecting one path from a group of paths on which to continue by a positional indicator.

8. The method of accessing a data base structure of Claim 3 further including the step of tagging intermediate objects of a sequence of data base objects, said tagged objects capable of being accessed by said rule.

9. In a circuit design synthesis procedure, a syntax for the synthesis procedure rule structure comprising:
a consequence portion for said rule determining an activity for said synthesis procedure when a predetermined condition is identified; and
an antecedent portion for said rule specifying how said predetermined condition is identified, said antecedent portion including a selected name replacing a plurality of linked objects.

10. The syntax for a circuit design synthesis rule structure of Claim 9 wherein said selected name can replace a plurality of groups of linked object names.

## FIG. I.

11 — ENTER COMPONENT DEFINITIONS
FROM A LIBRARY INTO PRIMITIVE
MODEL DEFINITIONS DATA STRUCTURES

12 — ENTER DESIGN DATA FOR INSTANCES
ALONG WITH CONNECTIVITY
INFORMATION

13 — RELATE DESIGN INSTANCES TO THE
LIBRARY OF MODEL DEFINITIONS

14 — ALTER AND CONNECT THE DESIGN
INSTANCES IN SUCH A WAY AS
TO ACHIEVE OPTIMUM CHARACTERISTICS
OF SIZE, PATH DELAY POWER, ETC.
ACCORDING TO A SET OF RULES

PREPARE CIRCUIT DESIGN IN
A FORMAT FOR USE WITH AN
AUTOMATED FABRICATION SYSTEM

15

## FIG. 2.

```
21 ── ENTER ABSTRACT COMPONENT DATA
       FROM LIBRARY INTO MODEL
       DEFINITION DATA STRUCTURES
                  │
                  ▼
22 ── ENTER TARGET TECHNOLOGY
       COMPONENT DATA FROM LIBRARY
       INTO MODEL DEFINITION DATA
              STRUCTURES
                  │
                  ▼
23 ── ENTER DESIGN DATA WITH
       CONNECTED INSTANCES OF THE
         ABSTRACT COMPONENTS
                  │
                  ▼
24 ── SET UP POINTERS FOR PATH
       TRAVERSAL AND POINTERS TO
           ASSOCIATED RULES
                  │
                  ▼
25 ── TEST ASSOCIATED RULES AND
       WHEN 'TRUE', APPLY RULE RESULTS
                  │
                  ▼
26 ── REPEAT STEP 25
       UNTIL CIRCUIT DESIGN IS STABILIZED
                  │
                  ▼
27 ── PREPARE CIRCUIT DESIGN IN
        FORMAT FOR USE WITH AN
       AUTOMATED FABRICATION SYSTEM
```

FIG. 3.

0 267 379

# FIG. 4.

0 267 379

*FIG. 5.*

0 267 379

FIG. 6.

FIG. 7.

0 267 379

# FIG. 8.

0 267 379

## FIG. 9.